# EUROPÄISCHE PATENTSCHRIFT

(11) **EP 0 422 488 B1**
(45) Veröffentlichungstag und Bekanntmachung des Hinweises auf die Patenterteilung: **03.04.1996**
(21) Anmeldenummer: 90118919.1
(22) Anmeldetag: 04.10.1990
(51) Int. Cl.: G03F 7/033, C08F 287/00

(54) **Photopolymerisierbare Gemische und diese enthaltende lichtempfindliche Aufzeichnungselemente**
Photopolymerisable mixtures and photosensitive recording elements containing such mixtures
Mélanges photopolymérisables et éléments d'enregistrement photosensibles contenant ces mélanges

(30) Priorität: 13.10.1989 DE 3934177
(43) Veröffentlichungstag der Anmeldung: 17.04.1991
(73) Patentinhaber: BASF Aktiengesellschaft, D-67063 Ludwigshafen (DE)
(72) Erfinder: Bronstert, Klaus, Dr., W-6719 Carlsberg (DE); Hoffmann, Gerhard, Dr., W-6701 Otterstadt (DE); Kurtz, Karl-Rudolf, Dr., W-6900 Heidelberg (DE)

(56) Entgegenhaltungen:
- EP-A- 0 248 300

## Beschreibung

Die vorliegende Erfindung betrifft photopolymerisierbare Gemische zur Herstellung von lichthärtenden Überzügen, weichelastischen Folienbahnen und insbesondere photopolymeren Relief- oder Druckformen, die neben einem Photoinitiator und mindestens einer photopolymerisierbaren, ethylenisch ungesättigten niedermolekularen Verbindung mindestens ein elastomeres Blockcopolymerisat als Bindemittel enthalten. Die Erfindung betrifft des weiteren lichtempfindliche Aufzeichnungselemente, insbesondere zur Herstellung von Flexodruckformen, mit einer auf einem dimensionsstabilen Träger aufgebrachten lichtempfindlichen Aufzeichnungsschicht aus einem photopolymerisierbaren Gemisch der vor erwähnten Art.

Photopolymerisierbare Gemische für die Herstellung von Überzügen und Formteilen, insbesondere Reliefdruckplatten für den Flexodruck, sind an sich seit langem bekannt. So werden z.B. in der US-A-3 674 486, der GB-A-1 366 769, der US-A-4 320 188 sowie der DE-A-28 15 678 solche photopolymerisierbaren Gemische beschrieben, die als Bindemittel spezielle elastomere Styrol/Dien-Mehrblockcopolymerisate enthalten. Diese photopolymerisierbaren Gemische zeichnen sich u.a. durch ihre geringe Neigung zum kalten Fluß, die hieraus hergestellten Flexodruckplatten insbesondere durch ihre guten weichelastischen Eigenschaften aus. In der EP-A-230 300 werden durch Photopolymerisation vernetzbare Gemische u.a. für die Herstellung von Relief- und Druckformen beschrieben, die als Bindemittel elastomere Polymerisate, insbesondere Styrol/Dien-Blockcopolymerisate, mit anionischen Endgruppen enthalten. Diese aus der EP-A-230 300 bekannten Gemische zeichnen sich u.a. durch ihre leichte Verarbeitbarkeit aus.

Ein Nachteil dieser bekannten, elastomere Blockcopolymerisate als Bindemittel enthaltenden photopolymerisierbaren Gemische ist, daß die hieraus hergestellten Reliefdruckplatten, insbesondere wenn sie auf Druckzylinder aufgespannt sind, zur Bildung von Rissen in der Druckplattenoberfläche neigen. Durch diese Rißbildung wird die Qualität der Drucke stark beeinträchtigt und eine einmal hergestellte Druckplatte innerhalb von wenigen Tagen für die Wiederverwendung ungeeignet. Ferner läßt ihre Beständigkeit gegenüber Ozon, dem die Flexodruckplatten beispielsweise bei einer kurzwelligen UV-Nachbelichtung entsprechend der EP-A-17 927 ausgesetzt sind, zu wünschen übrig. Des weiteren hat es sich gezeigt, daß diese bekannten photopolymerisierbaren Gemische für die Herstellung von Endlos-Druckformen, beispielsweise nach dem in der DE-A-27 22 896 beschriebenen Verfahren, nur schlecht geeignet sind. Bei der Herstellung von Endlosdruckformen müssen die photopolymerisierbaren Schichten nach dem Aufbringen auf einen Formzylinder oder eine Formzylinderhülse im allgemeinen mechanisch, insbesondere durch Schleifen, Drehen oder Spänen, nachbearbeitet werden, was aber bei den Druckformen aus den bekannten photopolymerisierbaren Gemischen auf Basis von elastomeren Blockcopolymerisaten wegen ihrer elastischen Verformung große Schwierigkeiten bereitet. Die aus der EP-A-230 300 bekannten, durch Photopolymerisation vernetzbaren Gemische haben zudem den Nachteil, daß ihre Eigenschaften durch geringe Mengen von freien Säuren negativ verändert werden können.

Aufgabe der vorliegenden Erfindung war es, neue photopolymerisierbare Gemische aufzuzeigen, die kriechfest sind und auch im gehärteten Zustand gute elastische Eigenschaften besitzen, die aber nicht die oben angeführten Nachteile aufweisen. Auch war es Aufgabe der vorliegenden Erfindung, neue, leicht verarbeitbare photopolymerisierbare Gemische aufzuzeigen, die sich mit besonderem Vorteil für die Herstellung von Überzügen, weichelastischen Folienbahnen oder Beschichtungen und insbesondere von kautschukelastischen Druckplatten für den Flexodruck eignen. Die aus den neuen photopolymerisierbaren Gemischen hergestellten Produkte sollen dabei unter den Bedingungen ihrer Anwendung möglichst rißbeständig und ozonresistent sein und problemlos mittels mechanischer, materialabtragender Verfahren bearbeitet werden können.

Es wurde nun überraschenderweise gefunden, daß diese Aufgabe durch solche photopolymerisierbaren Gemische auf der Grundlage von löslichen elastomeren Blockcopolymerisaten als Bindemittel, hiermit verträglichen photopolymerisierbaren Monomeren und Photoinitiatoren gelöst wird, die als polymeres Bindemittel mindestens ein spezielles elastomeres Copolymerisat der nachstehend näher definierten Art enthalten.

Gegenstand der Erfindung ist dementsprechend ein photopolymerisierbares Gemisch, enthaltend
(a) wenigstens 40 Gew.-%, bezogen auf das photopolymerisierbare Gemisch, mindestens eines löslichen, elastomeren Blockcopolymerisats als polymeres Bindemittel,
(b) wenigstens 1 Gew.-%, bezogen auf das photopolymerisierbare Gemisch, mindestens einer mit dem polymeren Bindemittel (a) verträglichen, photopolymerisierbaren, ethylenisch ungesättigten niedermolekularen Verbindung,
(c) 0,01 bis 10 Gew.-%, bezogen auf das photopolymerisierbare Gemisch, mindestens eines Photopolymerisationsinitiators sowie
(d) 0 bis 40 Gew.-%, bezogen auf das photopolymerisierbare Gemisch, an weiteren Hilfs- und/oder Zusatzstoffen,
welches dadurch gekennzeichnet ist, daß als Bindemittel (a) elastomere Vinylaromat/Dien-Blockcopolymerisate mit mindestens einem thermoplastischen, nicht-elastomeren Polymerblock A und mindestens einem elastomeren Polymerblock B enthalten sind, welche Endgruppen der allgemeinen Formel (I), (II) oder (III) 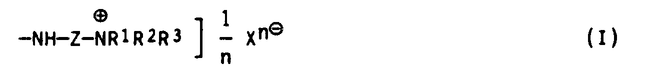 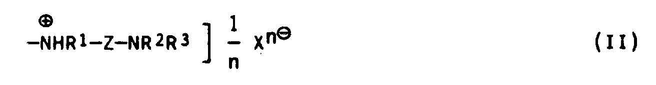 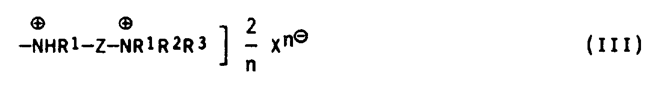 aufweisen, worin bedeuten
- Z:: einen zweibindigen, ggf. substituierten Kohlenwasserstoffrest oder eine direkte Einfachbindung,
- R¹:: ein Wasserstoffatom oder einen organischen Quaternisierungsrest, wie eine Alkylgruppe, insbesondere mit 1 bis 4 C-Atomen,
- R, R³:: gleich oder verschieden und unabhängig voneinander, ein Wasserstoffatom, einen aliphatischen, cycloaliphatischen oder aromatischen Rest, insbesondere mit 1 bis 12 C-Atomen, eine -CO-Y-COOH-Gruppe (mit Y = Rest eines cyclischen Dicarbonsäureanhydrids) oder R und R³ zusammen eine Brücke mit 3 bis 12, ggf. durch aliphatische oder aromatische Reste substituierten, Kohlenstoffgliedern,
- X:: einen anorganischen oder organischen Säurerest sowie
- n:: eine ganze Zahl, die die negative Wertigkeit des Säurerests X angibt.

Gegenstand der Erfindung sind weiterhin spezielle Ausgestaltungsformen dieser photopolymerisierbaren Gemische gemäß der nachfolgenden detaillierten Beschreibung.

Gegenstand der Erfindung sind ferner lichtempfindliche Aufzeichnungselemente, insbesondere zur Herstellung von Druckplatten für den Flexodruck, mit einer auf einem dimensionsstabilen Träger haftfest aufgebrachten photopolymerisierbaren Aufzeichnungsschicht, wobei diese photopolymerisierbare Aufzeichnungsschicht aus einem erfindungsgemäßen photopolymerisierbaren Gemisch der vorstehend genannten Art gebildet wird.

Die Endgruppen der vorstehenden allgemeinen Formeln (I), (II) und (III) werden der Einfachheit halber nachfolgend zusammenfassend auch als "Endgruppen E" bezeichnet.

Auch wenn in der EP-A-248 300 bereits allgemein Homopolymere und Blockcopolymere aus Vinylaromaten und/oder Dienen mit Endgruppen E beschrieben sind, so war es doch überraschend, daß die Verwendung der erfindungsgemäß als Bindemittel einzusetzenden speziellen elastomeren Blockcopolymerisate in den photopolymerisierbaren Gemischen bzw. den lichtempfindlichen Aufzeichnungselementen zu Produkten mit einem besonders vorteilhaften Eigenschaftsprofil führt. Beispielsweise war es keineswegs zu erwarten, daß die erfindungsgemäßen elastomeren photopolymerisierbaren Gemische - im Gegensatz zu den vergleichbaren bekannten photopolymerisierbaren Gemischen der in Rede stehenden Art - ohne große Probleme einer mechanischen, materialabtragenden Behandlung, wie beispielsweise Schleifen, Drehen, Fräsen oder der gleichen, unterworfen werden können. Auch die im Vergleich zu den aus dem Stand der Technik bekannten photopolymerisierbaren Gemischen verbesserten anwendungstechnischen Eigenschaften der erfindungsgemäßen photopolymerisierbaren Gemische war aus dem Stand der Technik nicht herzuleiten.

Die photopolymerisierbaren Gemische der Erfindung enthalten als Bindemittel-Komponente (a) aus Vinylaromaten und Dienen aufgebaute, elastomere Blockcopolymerisate mit mindestens einem thermoplastischen, nicht-elastomeren Block A und mindestens einem elastomeren Polymerblock B, wobei diese Blockcopolymerisate Endgruppen E entsprechend den allgemeinen Formeln (I), (II) oder (III) enthalten. Auch wenn es möglich ist, daß die erfindungsgemäß einzusetzenden elastomeren Blockcopolymerisate mehrere Endgruppen E in einem Polymermolekül aufweisen, so enthalten sie in der Regel doch nur eine Endgruppe E pro Polymermolekül. Erfindungsgemäß als Bindemittel (a) besonders geeignete elastomere Blockcopolymerisate lassen sich durch die allgemeine Formel (IV)

(A-B)̵ₚE (IV)

wiedergeben, worin A für einen thermoplastischen, nicht-elastomeren Polymerblock, B für einen elastomeren Polymerblock, p für eine ganze Zahl im Bereich von 1 bis 4 und E für eine Endgruppe entsprechend einer der allgemeinen Formeln (I), (II) oder (III) stehen. In der allgemeinen Formel (IV) steht p insbesondere für die Zahl 1. Der thermoplastische, nicht-elastomere Polymerblock A hat im allgemeinen eine Glasübergangstemperatur über 20°C und weist vorzugsweise ein Molekulargewicht im Bereich von 1500 bis 150 000, insbesondere im Bereich von 5000 bis 100 000 und besonders vorteilhaft im Bereich von 5000 bis 50 000, auf. Der Anteil des thermoplastischen, nicht-elastomeren Polymerblocks A in den elastomeren Blockcopolymerisaten liegt dabei üblicherweise im Bereich von etwa 3 bis 40 Gew.-%, vorzugsweise im Bereich von etwa 5 bis 25 Gew.-%, bezogen auf die Summe der Polymerblöcke A + B. Die elastomeren Polymerblöcke B in den erfindungsgemäß einzusetzenden elastomeren Blockcopolymerisaten der allgemeinen Formel (IV) haben üblicherweise eine Glastemperatur unterhalb von 15°C, vorzugsweise unterhalb von 0°C und insbesondere kleiner als -15°C. Die elastomeren Polymerblöcke B machen - korrespondierend zu dem Anteil der Polymerblöcke A - üblicherweise etwa 60 bis 97 Gew.-%, vorzugsweise 5 bis 75 Gew.-%, bezogen auf die Summe aller Polymerblöcke A + B, aus; ihre Molmasse liegt im allgemeinen im Bereich von 10 000 bis 200 000, insbesondere im Bereich von 15 000 bis 150 000 und vorzugsweise im Bereich von 20 000 bis 100 000.

Die erfindungsgemäß als Bindemittel (a) in den photopolymerisierbaren Gemischen enthaltenen. elastomeren Blockcopolymerisate sind, abgesehen von den Endgruppen E, aus Vinylaromaten und konjugierten Dienen aufgebaut. Beispiele für geeignete Vinylaromaten sind Styrol, α-Methylstyrol, para-Methylstyrol, para-tert.-Butylstyrol oder 1-Vinylnaphthalin, wobei Styrol als Vinylaromat für den Aufbau der elastomeren Blockcopolymerisate bevorzugt ist. Als Beispiele für geeignete konjugierte Diene seien Butadien, Isopren, Penta-1,3-dien, 2,3-Dimethylbutadien oder Hexa-2,4-dien genannt, wobei von den Dienen insbesondere Butadien und/oder Isopren bevorzugt für die Herstellung der elastomeren Blockcopolymerisate eingesetzt werden.

Als Bindemittel (a) für die erfindungsgemäßen photopolymerisierbaren Gemische eignen sich dabei besonders solche elastomeren Blockcopolymerisate der allgemeinen Formel (IV), bei denen der thermoplastische, nicht-elastomere Polymerblock A aus einem Homo- oder Copolymerisatblock aus Vinylaromaten oder einem Copolymerisatblock aus Vinylaromaten und konjugierten Dienen und der elastomere Polymerblock B aus einem Homo- oder Copolymerisatblock aus konjugierten Dienen oder einem Copolymerisatblock aus konjugierten Dienen und Vinylaromaten gebildet wird. Vorzugsweise handelt es sich bei dem thermoplastischen, nicht-elastomeren Polymerblock A um einen Homo-Polystyrolblock oder um einen Copolymerblock, der überwiegende Mengen an Styrol und untergeordnete Mengen an Butadien und/oder Isopren einpolymerisiert enthält. Bei dem elastomeren Polymerblock B handelt es sich insbesondere um einen Homo-Polybutadienblock, einen Homo-Polyisoprenblock, einen Butadien/Isopren-Copolymerblock oder einen Copolymerblock, der überwiegende Mengen an Butadien und/oder Isopren sowie untergeordnete Mengen an Styrol einpolymerisiert enthält. Die elastomeren Blockcopolymerisate können in den erfindungsgemäßen photopolymerisierbaren Gemischen auch in ganz oder teilweise hydrierter Form eingesetzt werden.

Neben den thermoplastischen, nicht-elastomeren Polymerblöcken A und den elastomeren Polymerblöcken B enthalten die erfindungsgemäß einzusetzenden elastomeren Blockcopolymerisate Endgruppen E gemäß einer der vorstehend angeführten allgemeinen Formeln (I), (II) oder (III). In den allgemeinen Formeln (I) bis (III) für die Endgruppen E steht Z zum einen für eine Einfachbindung zwischen den beiden Stickstoffatomen, d.h. also eine N-N-Bindung. Andererseits kann Z auch einen zweiwertigen Kohlenwasserstoffrest, der ggf. substituiert sein kann, darstellen. In diesem Fall steht Z insbesondere für eine, ggf. substituierte, Polymethylenbrücke mit 2 bis 12 Kohlenstoffatomen als Brückengliedern, eine cycloaliphatische Brücke oder eine Phenylenbrücke, wobei als Substituenten z.B. Alkyl-Gruppen, wie Methyl oder Ethyl, Phenyl-Gruppen oder auch Alkylidenamino-Gruppen in Betracht kommen. Bevorzugt ist Z eine Polymethylenbrücke mit 2 oder 3 Brücken-Kohlenstoffatomen, wobei als mögliche Substituenten insbesondere eine oder zwei Methyl-Gruppen in Betracht kommen. Als Beispiele für solche Polymethylenbrücken Z seien die -CH₂-CH₂-Gruppe, die -CH₂-CH₂-CH₂-Gruppe und die -CH₂-C(CH₃)₂-CH₂-Gruppe genannt.

In den allgemeinen Formeln (I) bis (III) stellt R¹ insbesondere ein Wasserstoffatom dar. R¹ kann aber auch ein organischer Quaternisierungsrest sein, wie er beispielsweise aus den für die Quaternisierung von Amin-Gruppen üblicherweise verwendeten und bekannten Quaternisierungs- bzw. Alkylierungsmitteln stammt. Als Quaternisierungsrest kommen dabei insbesondere Alkylgruppen mit 1 bis 4 C-Atomen, wie die Methyl-Gruppe, aber auch beispielsweise die Benzyl-Gruppe in Betracht. In den allgemeinen Formeln (I) bis (III) können die Reste R und R³ jeweils gleich oder voneinander verschieden sein. Insbesondere stehen dabei R und R³, unabhängig voneinander, jeweils entweder für ein Wasserstoffatom, eine Alkylgruppe, vorzugsweise mit 1 bis 4 C-Atomen, insbesondere eine Methylgruppe, oder einen Phenylrest. Die Reste R2 und R3 können aber auch zusammen unter Ausbildung eines Ringsystems eine Kohlenwasserstoff-Brücke, z.B. eine Polymethylen-Brücke, insbesondere mit 4 oder 5 Brücken-C-Atomen bilden, wobei diese Brücke ggf. auch substituiert sein kann, beispielsweise durch Alkylreste mit 1 bis 4 C-Atomen oder durch Phenyl-Gruppen. Die Reste R oder R³ können darüberhinaus auch eine -CO-Y-COOH-Gruppe darstellen, worin Y den Rest eines cyclischen Dicarbonsäureanhydrids, wie beispielsweise eine -(CH₂)₂-Gruppe, eine -(CH₂)₃-Gruppe oder eine Phenylen-Gruppe, bedeutet. Für den Fall, daß einer der Reste R oder R³ für einen solchen Rest eines cyclischen Dicarbonsäureanhydrids steht, ist der jeweils andere der Reste R2 oder R3 vorzugsweise ein Wasserstoffatom oder eine Alkylgruppe mit 1 bis 4 C-Atomen, wie beispielsweise die Methylgruppe. Als besonders geeignet für die erfindungsgemäß einzusetzenden elastomeren Blockcopolymerisate haben sich beispielsweise die folgenden Endgruppen E erwiesen:

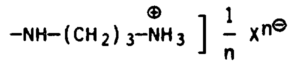

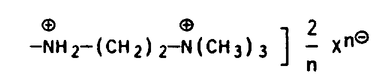

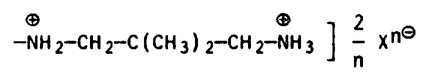

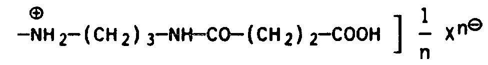

Der Säurerest X, als Gegenion für die Bildung der Ammoniumsalze in den Endgruppen E, kann an sich von allen denkbaren anorganischen und organischen Säuren stammen, sofern diese Säuren ausreichend dissoziieren. Sehr schwache Säuren, wie beispielsweise Kohlensäure oder Kieselsäure, aber auch stark oxidierende Säuren, wie beispielsweise Salpetersäure oder Chlorsäure, sind als solche für die Herstellung der Endgruppen E weniger geeignet. Für die Herstellung dieser Endgruppen E ist der Einsatz von solchen Säuren von Vorteil, die mit dem unpolaren Teil der erfindungsgemäß einzusetzenden elastomeren Blockcopolymerisate unverträglich sind. Als Beispiele für anorganische Säurereste, die sich als Gegenion X in den Endgruppen E gut eignen, seien genannt: Chlorid, Bromid, Iodid, Perchlorat, Sulfat, Sulfit, Phosphat, Diphosphat, Polyphosphat, Phosphit, Arsenat und Antimonat. Als organische Säurereste kommen die Reste von Mono- und Polycarbonsäuren in Betracht, wobei hier insbesondere mehrbasische und solche mit hohen Dissoziationskonstanten geeignet sind. Als Beispiele solcher organischen Säuren seien genannt: Oxalsäure, Bernsteinsäure, Maleinsäure, Zitronensäure, Weinsäure, Ascorbinsäure, Benzoesäure, Isophthalsäure, Terephthalsäure, Mono- und Polysulfonsäuren und Carbonsulfonsäuren von Aromaten und Aliphaten. Ferner kann sich der Säurerest X von der Harnsäure, Trifluoressigsäure, Mono-, Di- und Trichloressigsäure, Trifluormethansulfonsäure, Acrylsäure, Methacrylsäure und dergleichen herleiten. Als besonders geeignet für die Bildung des Säurerestes X in den Endgruppen E der erfindungsgemäß einzusetzenden elastomeren Blockcopolymerisate haben sich dabei u.a. Oxalsäure und Phosphorsäure erwiesen, aber auch Bernsteinsäure bzw. Bernsteinsäureanhydrid.

Die Herstellung der erfindungsgemäß als Bindemittel (a) einzusetzenden elastomeren Blockcopolymerisate kann nach den an sich bekannten Methoden erfolgen. In diesem Zusammenhang sei beispielsweise auf die EP-A-248 300 verwiesen. Hierzu werden in einem ersten Schritt die Ausgangspolymere mit den Diaminendgruppen hergestellt, indem lebende anionische oder mit Alkalimetall metallisierte elastomere Blockcopolymerisate aus den Vinylaromaten und Dienen z.B. mit bicyclischen Diaziridinen bzw. difunktionellen Schiff'schen Basen oder Hydrazonen umgesetzt und dann hydrolisiert und ggf. hydriert werden. Die entsprechenden Verfahren sind u.a. in der EP-A-211 395 beschrieben. Vorzugsweise geht man für die Herstellung der erfindungsgemäß einzusetzenden elastomeren Blockcopolymerisate von lebenden anionischen Vinylaromat/Dien-Blockcopolymerisaten aus, wie sie durch sequentielle anionische Polymerisation von Vinylaromaten und konjugierten Dienen mit den bekannten metallorganischen Initiatoren, insbesondere Lithiumalkylen, erhältlich sind. Diese "lebenden" Blockcopolymerisate mit Carbanionen an den Kettenenden, die insbesondere eine Struktur der allgemeinen Formel (V)

(A-B)ₚ ^{⊖} M^{⊕} (V)

aufweisen (worin A, B und p die weiter oben angegebene Bedeutung haben und M für das Metall aus dem metallorganischen Initiator, insbesondere für Lithium, steht), werden dann mit den bicyclischen Diaziridinen, difunktionellen Schiff'schen Basen oder Hydrazonen zu den entsprechenden Blockcopolymerisaten mit - noch nicht quaternisierten - Diaminendgruppen umgesetzt. Aus diesen Blockcopolymerisaten mit den - noch nicht quaternisierten - Diaminendgruppen werden dann die erfindungsgemäß einzusetzenden elastomeren Blockcopolymerisate mit den kationischen Ammonium-Endgruppen gemäß den allgemeinen Formeln (I), (II) oder (III) in ebenfalls üblicher und an sich bekannter Weise durch Zugabe von Säuren oder entsprechenden Alkylierungsmitteln erhalten. Beispiele für geeignete Säuren bzw. Quaternisierungsmittel wurden vorstehend bereits angeführt.

Um einen besonders guten Effekt zu erzielen, sollen mehr als 60 mol-%, insbesondere bis zu 100 mol-%, der Polymermoleküle endständige Basenstickstoffgruppen E tragen. Geeignet sind dabei nur solche Polymere, deren Endgruppe E jeweils 2 basische Stickstoffatome, wie oben formuliert, enthält.

Bei der Umsetzung der Blockcopolymerisate mit den - noch nicht quaternisierten - Diaminendgruppen kommen vorzugsweise wenigstens 0,7 mol Säure je Mol der in den Blockcopolymerisaten enthaltenen Aminendgruppen zur Anwendung. Bei geringeren Mengen werden die modifizierten Eigenschaften durch Ionisierung der Blockcopolymerisate nicht voll entwickelt. Es hat sich als vorteilhaft erwiesen, die Säure den Blockcopolymerisaten mit den - noch nicht quaternisierten - Diaminendgrupen in Mengen über den Äquivalenzpunkt hinaus zuzugeben. Beispielsweise hat sich der Zusatz von bis zu 5 Mol Säure je Mol der in den Blockcopolymerisaten enthaltenen Aminendgruppen als zweckmäßig erwiesen. Die zusätzlich über den Äquivalenzpunkt hinaus aufgenommenen Säuremengen führen zu einer Verstärkung der Aggregation der kationischen Kettenenden der Blockcopolymerisate, wobei schließlich bei mehrfachem Überschuß über den Äquivalenzpunkt hinaus ein Eigenschaftsplateau erreicht wird, so daß eine Säurezugabe über diesen Punkt hinaus nicht weiter sinnvoll ist. Die Säuren sind auch bei großem Überschuß überraschend gut an die Blockcopolymerisate gebunden; der Säuregehalt wird z.B. durch Fällen der Blockcopolymerisate aus ihren Lösungen mit Alkohol oder durch Waschen der Polymerlösungen nur wenig verändert. Die Umsetzung der Säuren mit den Blockcopolymerisaten mit den - noch nicht quaternisierten - Diaminendgruppen unter Bildung der erfindungsgemäß einzusetzenden Blockcopolymerisate mit den kationischen Endgruppen kann nach verschiedenen, an sich bekannten Methoden erfolgen, wie sie u.a. in den vorgenannten Literaturstellen beschrieben sind. Anstelle der freien Säuren kann man auch ihre Ammoniumsalze in sehr konzentrierter Lösung in Wasser, Tetrahydrofuran oder einem anderen geeigneten Lösungsmittel verwenden. Auch ist es möglich, für die Kationisierung der Aminendgruppen z.B. die bekannten Alkylierungsmittel einzusetzen. Anstelle einer Säure kann man natürlich auch Mischungen verschiedener Säuren für die Kationisierung der Aminendgruppen der Blockcopolymerisate verwenden. Es hat sich weiterhin gezeigt, daß bei Mitverwendung von SO₂ besondes helle Umsetzungsprodukte erhalten werden. Außer Schwefeldioxid wurden zur Aufhellung der Farbe der erfindungsgemäß einzusetzenden Blockcopolymerisate auch noch andere Additive als wirksam gefunden. So zeigen Harnstoff und seine Derivate, die noch mindestens ein freies Wasserstoffatom enthalten, gute Wirkung. Gut geeignet in diesem Sinn ist außerdem der Zusatz von geringen Mengen an Aluminiumalkylen oder -hydriden, ferner auch Borhydrid.

Die erfindungsgemäß als Bindemittel (a) einzusetzenden elastomeren Blockcopolymerisate weisen vorteilhafterweise eine Viskositätszahl VZ im Bereich von 70 bis 300 ml/g, bevorzugt im Bereich von 80 bis 250 ml/g, auf (gemessen bei 25°C mit einer Lösung von 0,5 g Polymer in 120 cm³ Toluol). Die Deformationshärte (bestimmt nach DIN 53514) der erfindungsgemäß einzusetzenden elastomeren Blockcopolymerisate liegt vorteilhafterweise im Bereich von 2000 bis 30 000, insbesondere von 2500 bis 25 000; ihre Deformationselastizität (bestimmt nach DIN 53514) liegt bevorzugt im Bereich von 25 bis 65, insbesondere im Bereich von 30 bis 60. Von Vorteil ist es weiterhin, insbesondere für die Anwendung in Druckplatten für den Flexodruck, wenn die erfindungsgemäß einzusetzenden elastomeren Blockcopolymerisate eine Shore A-Härte (bestimmt nach DIN 53505) zwischen 10 und 80, bevorzugt im Bereich von 15 bis 70, aufweisen. Die erfindungsgemäß einzusetzenden elastomeren Blockcopolymerisate sind darüber hinaus in einem organischen Lösungsmittel bzw. Lösungsmittelgemisch löslich oder zumindest gut dispergierbar, was nicht nur im Hinblick auf ihre Verarbeitbarkeit Vorteile bringt, sondern auch für die Anwendung der erfindungsgemäßen photopolymerisierbaren Gemische für die Herstellung von Druckplatten von Bedeutung ist.

Je nach dem speziellen Anwendungszweck der erfindungsgemäßen photopolymerisierbaren Gemische ist es natürlich möglich, hierin als polymeres Bindemittel (a) auch Gemische der vorstehend beschriebenen elastomeren Blockcopolymerisate mit den Endgruppen E zu verwenden bzw. diese mit untergeordneten Mengen an anderen verträglichen Polymeren, insbesondere Elastomeren, abzumischen. Die erfindungsgemäßen photopolymerisierbaren Gemische enthalten das polymere Bindemittel (a) in einer Menge von wenigstens 40 Gew.-%, bezogen auf das photopolymerisierbare Gemisch. Vorzugsweise liegt der Anteil des polymeren Bindemittels (a) in den erfindungsgemäßen photopolymerisierbaren Gemischen im Bereich von 60 bis 97 Gew.-%, insbesondere im Bereich von 70 bis 96 Gew.-%, bezogen auf das photopolymerisierbare Gemisch.

Die photopolymerisierbaren Gemische der Erfindung enthalten als Komponente (b) mindestens eine photopolymerisierbare, ethylenisch ungesättigte niedermolekulare Verbindung, die mit dem polymeren Bindemittel (a) verträglich ist und im allgemeinen einen Siedepunkt bei Atmosphärendruck über 100°C besitzen soll. Als photopolymerisierbare ethylenisch ungesättigte niedermolekulare Verbindungen, die im allgemeinen ein Molekulargewicht unter 3000, vorzugsweise bis zu 2000 haben, kommen die für photopolymerisierbare Gemische der in Rede stehenden Art an sich bekannten photopolymerisierbaren Monomere und/oder Oligomere in Betracht, wie sie beispielsweise in den eingangs zitierten Druckschriften GB-A-1 366 769, US-A-4 320 188, DE-A-28 15 678 oder EP-A-230 300 beschrieben sind. Als Beispiele für geeignete photopolymerisierbare, ethylenisch ungesättigte niedermolekulare Verbindungen (b) seien besonders genannt die Ester der Acrylsäure und/oder Methacrylsäure mit ein- oder mehrwertigen Alkoholen, die 2 bis 20 Kohlenstoffatome aufweisen, wie Butyl(meth)acrylat, 2-Ethylhexyl(meth)acrylat, Lauryl(meth)acrylat, Ethylenglykol-di(meth)acrylat, Butandiol-1,4-di(meth)acrylat, Neopentylglykoldi(meth)acrylat, 3-Methylpentandioldiacrylat, Hexandiol-1,6-diacrylat, Hexandiol-1,6-dimethacrylat, 1,1,1-Trimethylolpropantriacrylat und -trimethacrylat, Di-, Tri- und Tetraethylenglykoldi(meth)acrylat, Tripropylenglykoldi(meth)acrylat, Pentaerythrittetra(meth)acrylat u.a. Ferner kommen als Komponente (b) der erfindungsgemäßen photopolymerisierbaren Gemische auch die Diester von Fumar- oder Maleinsäure in Betracht oder auch Umsetzungsprodukte aus OH-terminierten, oligomeren Polybutadienen mit Maleinsäureanhydrid oder (Meth)acrylsäure zu oligomeren Polybutadienen mit aktivierten, photopolymerisierbaren olefinischen Doppelbindungen. Ebenso geeignet als Komponente (b) sind auch die Umsetzungsprodukte von Acrylsäure und/oder Methacrylsäure mit Di- oder Polyepoxiden sowie die Umsetzungsprodukte von Di- oder Polycarbonsäuren mit Glycidylacrylat und/oder Glycidylmethacrylat. Die erfindungsgemäßen photopolymerisierbaren Gemische enthalten die photopolymerisierbaren, ethylenisch ungesättigten niedermolekularen Verbindungen (b) in einer Menge von wenigstens 1 Gew.-%, bezogen auf das photopolymerisierbare Gemisch. Vorzugsweise sind die photopolymerisierbaren, ethylenisch ungesättigten niedermolekularen Verbindungen (b) in den erfindungsgemäßen photopolymerisierbaren Gemischen in einer Menge zwischen 1 und 40 Gew.-%, insbesondere in einer Menge im Bereich von 2 bis 30 Gew.-% und besonders bevorzugt in einer Menge im Bereich von 3 bis 20 Gew.-%, jeweils bezogen auf das photopolymerisierbare Gemisch, enthalten.

Die erfindungsgemäßen photopolymerisierbaren Gemische enthalten darüberhinaus eine wirksame Menge, im allgemeinen 0,01 bis 10 Gew.-%, vorteilhafterweise 0,1 bis 8 Gew.-% und insbesondere 0,5 bis 5 Gew.-%, bezogen auf das photopolymerisierbare Gemisch, mindestens eines Photopolymerisationsinitiators. Beispiele für geeignete, verträgliche Photoinitiatoren sind Benzoin oder Benzoinderivate, wie dessen Methyl-, Isopropyl-, n-Butyl- oder Isobutylether; symmetrisch oder unsymmetrisch substituierte Benzilketale, wie Benzildimethylketal oder Benzilmethylethylketal; die als Photopolymerisationsinitiator wirksamen und bekannten Acyldiarylphosphinoxide und Acylarylphosphinsäurederivate, wie 2,6-Dimethoxybenzoyl-diphenylphosphinoxid, 2,4,6-Trimethylbenzoyl-diphenylphosphinoxid, 2,4,6-Trimethylbenzoyl-phenylphosphinsäure-Natriumsalz oder 2,4,6-Trimethylbenzoyl-phenylphosphinsäureethylester; substituierte oder unsubstituierte Chinone, wie Ethylanthrachinon oder Benzanthrachinon; oder Benzophenon oder Benzophenonderivate, wie 4,4'-Bis(dimethylamino)-benzophenon. Die Photopolymerisationsinitiatoren können in an sich bekannter Weise allein oder im Gemisch miteinander oder in Verbindung mit anderen Coinitiatoren oder Sensibilisatoren, beispielsweise tert.-Aminen, verwendet werden.

Die erfindungsgemäßen photopolymerisierbaren Gemische können ferner noch weitere Zusatz- und/oder Hilfsstoffe enthalten, wie sie zur Verbesserung der Handhabbarkeit und Verarbeitbarkeit von photopolymersierbaren Gemischen der in Rede stehenden Art oder auch zur Variation und Anpassung des Eigenschaftsprofils dieser Gemische üblich und bekannt sind. Hierzu gehören insbesondere thermische Polymerisationsinhibitoren zur Verhinderung der thermischen Polymerisation der photopolymerisierbaren Monomeren. Geeignete thermische Polymerisationsinhibitoren zeigen dabei im allgemeinen keine nennenswerte Eigenabsorption in dem aktinischen Bereich, in dem der Photopolymerisationsinitiator (c) absorbiert. Beispiele für geeignete Inhibitoren sind Hydrochinon, p-Methoxyphenol, 2,6-Di-tert.-butyl-p-kresol, Phenothiazin, Thiazinfarbstoffe wit Thioninblau G (C.I. 52025), Methylenblau B (C.I. 52015) oder Toluidinblau (C.I. 52040), oder N-Nitrosamine, wie N-Nitrosodiphenylamin oder die Salze, beispielsweise die Kalium-, Calcium-, Cer- oder Aluminiumsalze, des N-Nitrosocyclohexylhydroxylamins. Die thermischen Polymerisationsinhibitoren werden im allgemeinen in einer Menge von 0,001 bis 2 Gew.-%, vorzugsweise von 0,01 bis 1,5 Gew.-%, bezogen auf das photopolymerisierbare Gemisch, verwendet.

Zu den weiteren Zusatz- und/oder Hilfsstoffen, die in den erfindungsgemäßen photopolymerisierbaren Gemischen enthalten sein können, zählen beispielsweise Weichmacher, Antiozonantien, Farbstoffe, Pigmente, photochrome Zusätze, Mittel zur Verbesserung der Reliefstruktur, Antioxidantien, Füllstoffe, Verstärkerfüllstoffe, Flußmittel, Formtrennmittel, Vernetzungshilfsmittel und dergleichen. Der Anteil der Zusatz- und/oder Hilfsstoffe an dem photopolymerisierbaren Gemisch soll im allgemeinen insgesamt 40 Gew.-%, bezogen auf das photopolymerisierbare Gemisch, nicht übersteigen und liegt üblicherweise im Bereich von etwa 3 bis 30 Gew.-%, bezogen auf das photopolymerisierbare Gemisch.

Die erfindungsgemäßen photopolymerisierbaren Gemische können in an sich üblicher und bekannter Weise durch homogenes Vermischen der einzelnen Komponenten, beispielsweise in Lösung, einem Kneter oder Mischer, hergestellt werden. Die erfindungsgmäßen photopolymerisierbaren Gemische zeichnen sich durch ihre gute Verarbeitbarkeit aus und sind insbesondere zur Herstellung von lichthärtbaren Schichten, beispielsweise für überzüge, Beschichtungen, Lacke oder weichelastische Folienbahnen, geeignet. Lichthärtbare Schichten der gewünschten Schichtdicke aus den erfindungsgemäßen photopolymerisierbaren Gemischen können beispielsweise durch Gießen aus Lösung in einem geeigneten Lösungsmittel (wie z. B. Toluol, Xylol, Tetrahydrofuran oder dergleichen) auf entsprechende Schichtträger und Abdampfen des Lösungsmittels hergestellt werden. Ebenso können derartige Schichten auch durch Pressen, Extrudieren und Kalandrieren hergestellt werden. Die Schichtstärke ist in weiten Grenzen variierbar und je nach Anwendungszweck leicht einstellbar.

Besonders geeignet sind die erfindungsgemäßen photopolymerisierbaren Gemische für lichtempfindliche Aufzeichnungselemente zur Herstellung von Druckformen, insbesondere zur Herstellung von Flexodruckformen. Solche lichtempfindlichen Aufzeichnungselemente enthalten im allgemeinen eine oder mehrere photopolymerisierbare Aufzeichnungsschichten aus den erfindungsgemäßen photopolymerisierbaren Gemischen haftfest auf einem dimensionsstabilen Schichtträger aufgebracht, wobei die Schichtdicke der photopolymerisierbaren Aufzeichnungsschicht in den lichtempfindlichen Aufzeichnungselementen üblicherweise zwischen 0,01 und 6,5 mm liegt. Als Schichtträger für die lichtempfindlichen Aufzeichnungselemente eignen sich flexible, dimensionsstabile Materialien mit ausreichend hohem Elastizitätsmodul, wie z. B. Metallplatten oder -folien, beispielsweise aus Stahlblech, Aluminiumblech, Kupfer oder dergleichen, sowie Folien aus Hochpolymeren, wie z. B. Folien aus Polyethylenterephthalat, Polybutylenterephthalat, Polyamid oder Polycarbonat. Als Schichtträger kommen dabei sowohl Platten oder Folien als auch Zylinder oder Zylinderhülsen in Betracht. Die photopolymerisierbare Aufzeichnungsschicht der lichtempfindlichen Aufzeichnungselemente kann dabei direkt oder über Zwischenschichten mit dem dimensionsstabilen Schichtträger verbunden sein. Als Zwischenschichten kommen einerseits Haftschichten, beispielsweise auf Polyurethan-, Polychloropren- oder Phenoxiharz/Polycarbonat-Basis, in Betracht, andererseits aber auch beispielsweise weichelastische Unterschichten zur Erzielung höherer Plattendicken. Werden Schichtträger aus stark reflektierenden Materialien verwendet, kann es zweckmäßig und geraten sein, zwischen Schichtträger und photopolymerisierbarer Aufzeichnungsschicht eine oder mehrere Lichthofschutzschichten anzuordnen.

Es ist oft von Vorteil, wenn in den lichtempfindlichen Aufzeichnungselementen auf der dem Schichtträger abgewandten Oberfläche der photopolymerisierbaren Aufzeichnungsschicht noch eine dünne, klebfreie Deckschicht haftfest aufgebracht ist. Eine solche Deckschicht besteht vorzugsweise aus einem klebfreie, transparente und reißfeste Filme bildenden Polymeren, welches in dem Entwicklerlösungsmittel für die photopolymerisierbare Aufzeichnungsschicht löslich ist, wie z. B. einem Polyamid, Copolyamid, Polyurethan, Polyvinylalkohol, Polyvinylpyrrolidon, Polyethylenoxid mit einem Molekulargewicht über 100 000 und dergleichen. Diese Deckschichten, die üblicherweise eine Dicke von etwa 0,5 bis 20 µm besitzen, können gegebenenfalls auch mattiert sein.

Auf diesen haftfest aufgebrachten Deckschichten oder anstelle hiervon können die lichtempfindlichen Aufzeichnungselemente auf der dem Schichtträger abgewandten Oberfläche der photopolymerisierbaren Aufzeichnungsschicht auch mit einer abziehbaren Deckfolie versehen sein. Eine solche Deck- oder Schutzfolie, die beispielsweise aus Polyamid oder einem Polyester bestehen kann und die vorteilhafterweise eine Schichtstärke im Bereich von etwa 20 bis 150 µm besitzt, wird im allgemeinen vor der bildmäßigen Belichtung der lichtempfindlichen Aufzeichnungselemente abgezogen; bei hinreichender Transparenz dieser Deckschicht kann die Belichtung jedoch auch durch diese hindurch erfolgen, wobei die Deckschicht dann vor der Entwicklung abgezogen wird.

Die Herstellung der erfindungsgemäßen lichtempfindlichen Aufzeichnungselemente kann in an sich bekannter Weise, beispielsweise durch Auftragen der photopolymerisierbaren Aufzeichnungsschicht auf den dimensionsstabilen Träger mittels Gießens aus Lösung, Heißpressen, Kalandrieren oder Extrudieren, erfolgen. Der dimensionsstabile Träger kann dabei zuvor mit einer Haftschicht oder anderen gewünschten Zwischenschichten versehen worden sein. Anschließend können auf die photopolymerisierbare Aufzeichnungsschicht noch eine oder mehrere Deckfolien oder Deckschichten aufgebracht werden. Es ist aber auch möglich, beispielsweise die photopolymerisierbare Aufzeichnungsschicht zuerst auf dem als Deckschicht oder Deckfolie dienenden Material zu formen und anschließend die unbedeckte Seite der photopolymerisierbaren Aufzeichnungsschicht mit dem dimensionsstabilen Träger bzw. einer hierauf aufgebrachten Haft- oder Zwischenschicht, beispielsweise durch Kaschieren, haftfest zu verbinden.

Zur Herstellung von Relief- oder Druckformen, insbesondere für den Flexodruck, wird die photopolymerisierbare Aufzeichnungsschicht der erfindungsgemäßen lichtempfindlichen Aufzeichnungselemente in üblicher und bekannter Weise bildmäßig mit aktinischen Licht, insbesondere UV-Licht im Wellenlängenbereich von 300 bis 420 nm, belichtet. Geeignete Lichtquellen für aktinisches Licht sind z. B. handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen und dergleichen. Nach der bildmäßigen Belichtung werden die lichtempfindlichen Aufzeichnungselemente zur Herstellung der Relief- oder Druckformen mit einem Entwicklerlösungsmittel ausgewaschen, anschließend getrocknet sowie gegebenenfalls einer Nachbehandlung, beispielsweise einer Erwärmung, Nachbelichtung, insbesondere mit kurzwelligem UV-Licht, oder einer Oberflächenbehandlung mit Halogen enthaltenden wäßrigen Lösungen, unterworfen. Geeignete Entwicklerlösungsmittel sind u. a. aromatische Kohlenwasserstoffe, z. B. Toluol oder Ethylbenzol; Chlorkohlenwasserstoffe, wie z. B. Trichlorethan oder Tetrachlorethylen; Ketone, z. B. Methylisobutylketon; Terpene, wie z. B. Limonen; Benzinfraktionen, insbesondere mit niedrigem Aromatengehalt, oder Mischungen hiervon mit niedrigen Alkoholen, z. B. Butanol, Pentanol oder Ethylhexanol.

Die aus den erfindungsgemäßen lichtempfindlichen Aufzeichnungselementen hergestellten Relief- und Druckformen zeichnen sich nicht nur durch gute elastische Eigenschaften aus, sondern sind überraschenderweise unter den Bedingungen ihrer Anwendung äußerst rißbeständig und auch ozonresistent, so daß sie wiederholt verwendbar sind. Die erfindungsgemäßen lichtempfindlichen Aufzeichnungselemente mit der photopolymerisierbaren Aufzeichnungsschicht aus den erfindungsgemäßen photopolymerisierbaren Gemischen können mit besonderem Vorteil auch auf Formzylinder aufgebracht und dort, beispielsweise nach den in der DE-A-27 22 896 oder der EP-A-231 902 beschriebenen Verfahren, zu einer Endlosdruckform verarbeitet werden. Es hat sich gezeigt, daß die aus den erfindungsgemäßen photopolymerisierbaren Gemischen hergestellten Aufzeichnungsschichten im Gegensatz zu den bekannten elastomeren photopolymerisierbaren Aufzeichnungsschichten problemlos mechanisch, beispielsweise durch Schleifen, Drehen, Fräsen oder Spänen, bearbeitet werden können, wie es für die Herstellung von Endlosdruckschichten nach den bekannten und in den vorerwähnten Druckschriften beschriebenen Verfahren notwendig und erforderlich ist.

Die Erfindung wird durch die nachfolgenden Beispiele näher erläutert. Die in den Beispielen genannten Teile und Prozente beziehen sich, soweit nicht anders angegeben, auf das Gewicht. Die Shore A-Härte wurde nach DIN 53505, die Rückprallelastizität nach DIN 53512, die Reißdehnung nach DIN 53504 an Prüfkörpern S 2, die Deformationshärte und die Deformationselastizität nach DIN 53514 und die Viskositätszahl VZ nach DIN 51562 an Polymerlösungen aus 0,5 g Polymer in 120 ml Toluol bei 25 °C bestimmt. Die Molmassen der Blockcopolymerisate wurden durch Gelpermeationschromatographie ermittelt; Eichsubstanz waren Polystyrole unterschiedlicher Molmasse.

Für die folgenden Beispiele wurden zunächst nach den Vorschriften der EP-A-248 300 Blockcopolymerisate mit Diaminendgruppen des Typs

Polystyrol-Polybutadien-NH-Z-NH₂

hergestellt, wobei Z jeweils die in der folgenden Tabelle 1 angegebene Bedeutung hat. Der Anteil des Polystyrol-Blocks betrug jeweils 9 %, der des Polybutadien-Blocks jeweils 91 %, bezogen auf das Blockcopolymerisat ohne die Diaminendgruppen. Diese Blockcopolymerisate mit den Diaminendgruppen wurden dann mit den in der Tabelle 1 angegebenen Menge an Säuren bzw. Säureanhydrid kationisiert, wobei als weiterer Zusatzstoff Ethylenharnstoff mitverwendet wurde. Die charakteristischen Eigenschaften der so erhaltenen erfindungsgemäß zu verwendenden elastomeren Blockcopolymerisate sind ebenfalls in Tabelle 1 enthalten. Mit diesen Blockcopolymerisaten wurden die nachfolgenden Beispiele durchgeführt.

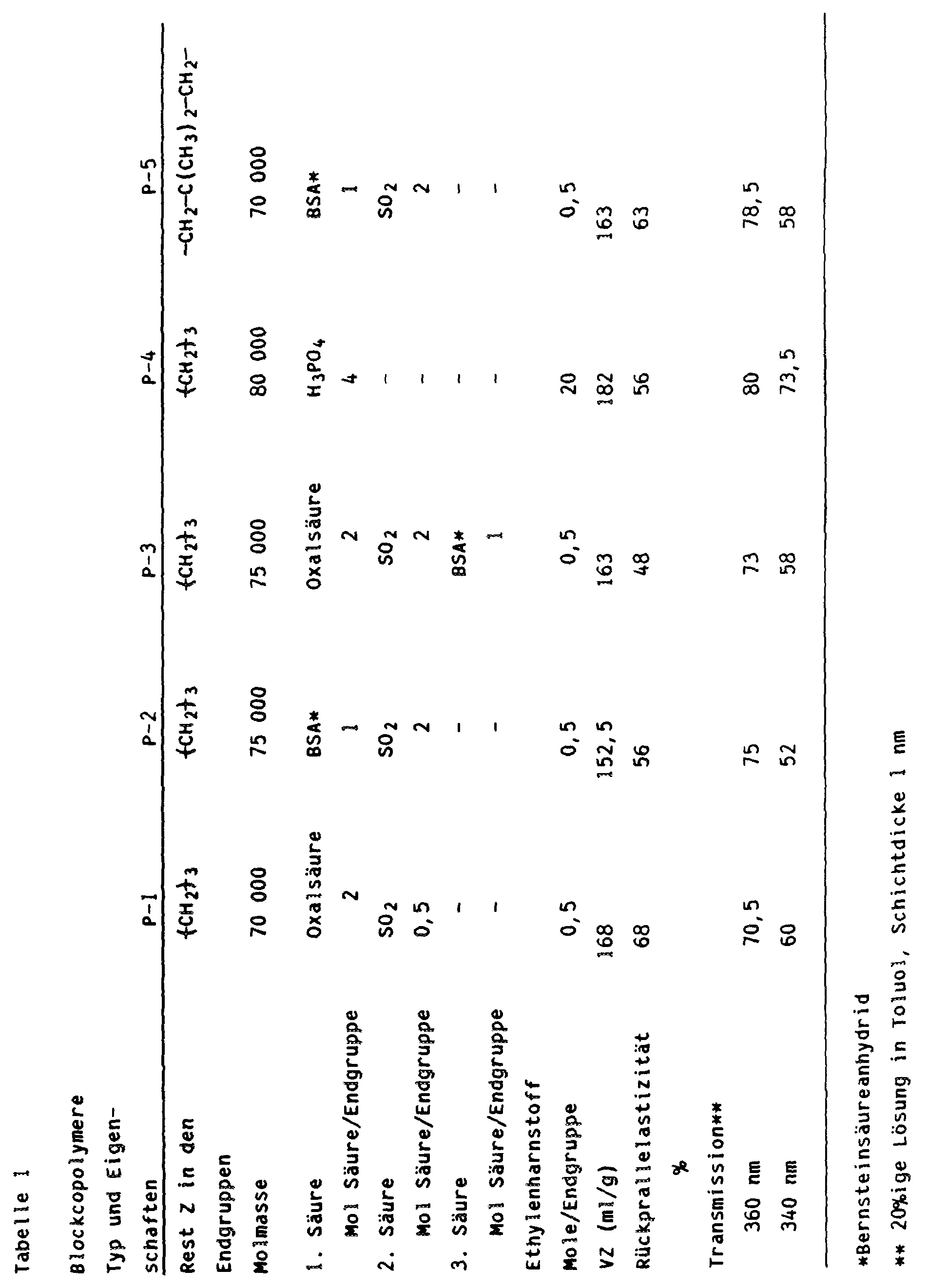

### Beispiel 1

100 Teile des Blockcopolymerisats P-1 gemäß Tabelle 1, 7,6 Teile 1,6-Hexandioldiacrylat, 3,7 Teile 1,6-Hexandioldimethacrylat, 1,4 Teile Benzildimethylketal und 0,6 Teile 2,6-Di-tert.-butyl-p-kresol wurden in 150 Teilen Toluol bei 65°C gelöst. Diese Lösung wurde auf einer 125 µm dicken Polyesterfolie mit Hilfe eines Rakelgießers so zu einer Schicht vergossen, daß nach dem Abdampfen des Toluols bei 80°C eine etwa 0,7 mm dicke, feste photopolymerisierbare Schicht zurückblieb.

Diese photopolymerisierbare Schicht wurde mit einer transparenten, 25 µm dicken Polyethylenfolie abgedeckt und dann mit einem mit 40 Watt UV-Röhren bestückten Flachbelichter 15 Minuten lang von der Vorder- und der Rückseite her vollflächig belichtet. Nach Entfernen der Träger- und Abdeckfolien erhielt man eine freitragende, photovernetzte weichelastische Folie mit einer Reißfestigkeit von 11,1 N/mm bei einer Reißdehnung von 265 %. Die Shore-A-Härte betrug 55; das Rückstellverhalten der Folie war sehr gut: Der Eindruck eines zylinderförmigen Stempels von 4 mm Durchmesser mit einem Auflagegewicht von 1000 g ging nach 2 Minuten Belastung und anschließenden 2 Minuten Endlastung auf 1,4 % zurück.

### Beispiel 2

Aus 180 g des Blockcopolymerisats P-2 gemäß Tabelle 1, 15,4 g 1,6-Hexandioldiacrylat, 7,6 g 1,6-Hexandioldimethacrylat, 2,8 g Benzildimethylketal, 1,15 g 2,6-Di-tert.-butyl-p-kresol, 10 g eines Paraffinöls (medizinisches Weißöl), 10 g eines p-Methylstyrol-α-Methylstyrol-Copolymerisats (Erweichungspunkt 95 - 110°C, Brechungsindex (25°C) = 1,58) und 230 g Toluol wurde eine Gießlösung und aus dieser in einem Gießrahmen eine photopolymerisierbare Schicht hergestellt, die nach dem Abdampfen des Toluols und Trocknen eine Dicke von 5,7 mm hatte. Diese photopolymerisierbare Schicht wurde auf jeder Seite mit transparenten Folien abgedeckt und 15 Minuten lang gleichzeitig vollflächig mit UV-Licht belichtet. Die resultierende, photovernetzte weichelastische Folie wies eine Shore-A-Härte von 55 und eine Rückprallelastizität von 62 % auf.

### Beispiel 3

Es wurde ein Gemisch durch Extrusion von 25,00 kg des granulierten Blockcopolymerisats P-3 gemäß Tabelle 1, 1,50 kg Paraffinöl (medizinisches Weißöl, aromatenfrei, Viskosität bei 25°C = 40 mpas, Dichte bei 15°C = 0,865 g/cm³), 1,01 kg 1,6-Hexandioldiacrylat, 0,49 kg 1,6-Hexandioldimethacrylat, 1,50 kg des p-Methylstyrol-α-Methylstyrol-Copolymerisats gemäß Beispiel 2, 0,36 kg Benzildimethylketal, 0,15 kg 2,6-Di-tert.-butyl-p-kresol und 1,8 kg Sudantiefschwarz (C.I. 26150) in einem Zweischneckenextruder hergestellt. Dazu wurden die flüssigen Bestandteile (Paraffinöl und Monomere) mit Farbstoff, Stabilisator und Photoinitiator vermischt, in den Extruder eingegeben, bei 135°C mit den thermoplastischen Komponenten vermischt und das resultierende Gemisch bei 150°C über eine Breitschlitzdüse ausgetragen. Mit Hilfe eines Kalanders wurde das ausgetragene Gemisch mit der einen Seite auf eine mit einer 5 µm dicken Phenoxiharz/Polycarbonat-Haftschicht bedeckten, 125 µm dicken Polyethylenterephthalatfolie als Trägerschicht laminiert, auf der anderen Seite mit einer mit Polyamid beschichteten Polyethylenterephthalat-Deckfolie bedeckt und das so erhaltene lichtempfindliche Aufzeichnungselement auf eine Gesamtschichtdicke von 3,00 mm gebracht.

Nach Abziehen der Polyethylenterephthalat-Deckfolie wurde die photopolymerisierbare Schicht des lichtempfindlichen Aufzeichnungselements durch eine Negativ-Bildvorlage bildmäßig mit einem handelsüblichen mit UV-Röhren bestückten Flachbelichter belichtet, nachdem das lichtempfindliche Aufzeichungselement zuvor von der Trägerseite her vollflächig vorbelichtet worden war. Nach der Entwicklung der bildmäßig belichteten Schicht mit einem Gemisch aus Perchlorethylen/n-Butanol wurde eine Reliefdruckplatte erhalten, die sich ausgezeichnet für den Flexodruck eignete. Die erhaltenen Drucke zeigten eine exakte Wiedergabe der Vorlage mit randscharfen Details; die Abriebfestigkeit, Quellung und Elastizität der Druckform waren sehr gut. Die Druckform zeigte auch nach längerer Lagerung und mehrfacher Wiederverwendung keine Rißbildung in der Druckformoberfläche, wodurch die Wiederverwendbarkeit eingeschränkt worden wäre. Zur Prüfung der Ozonresistenz wurde die Flexodruckform in einer Ozonkammer bei 24°C einer Luft mit einem Ozongehalt von 50 pphm ausgesetzt. Die ersten Ozonrisse zeigten sich erst nach 150 Minuten, während bei konventionellen photopolymeren Flexodruckplatten bereits erste Ozonrisse nach 30 Minuten auftraten.

### Beispiel 4

100 Teile des Blockcopolymerisats P-4 gemäß Tabelle 1, 20 Teile 1,6-Hexandioldimethacrylat, 0,6-Teile 2,6-Di-tert.-butyl-p-kresol und 1,5 Teile Benzildimethylketal wurden bei 60°C homogen miteinander vermischt. Es wurden Proben entnommen und auf Glas-, Metall- und Kunststoffplatten ausgegossen. Die resultierenden Lackfilme wurden mit Polyethylenfolien abgedeckt und 30 Minuten lang durch die Deckfolien hindurch vollflächig mit UV-Licht belichtet. Nach dem Abziehen der Deckfolien resultierten transparente Lackschichten hoher Beständigkeit.

### Beispiel 5

Aus einem Gemisch nach Beispiel 1, welches zusätzlich noch 0,001 Teile Sudantiefschwarz (C.I. 26150) enthielt, wurde, wie in Beispiel 1 beschrieben, auf einer polyamidbeschichteten Polyethylenterephthalatfolie eine 0,7 mm dicke reliefbildende photopolymerisierbare Aufzeichnungsschicht erzeugt. Mit Hilfe von Kaschierwalzen wurde dann auf die freie Oberfläche der photopolymerisierbaren Aufzeichnungsschicht eine mit einem Phenoxiharz/Polycarbonat-Haftlack beschichtete, 125 µm dicke Polyesterfolie laminiert. Der Haftlack enthielt als Lichthofschutzmittel ein Gemisch aus Auramin FA (Basic Yellow 2, C.I. 41000) und 4,4′-Bis-(N-β-hydroxiethyl-N-methylamino)-benzophenon in einem Gewichtsverhältnis von 4:1 und einer Extinktion von 0,40 bei einer Wellenlänge von 360 nm. Die mit dem Haftlack beschichtete Polyesterfolie bildete die Trägerschicht, die polyamidbeschichtete Polyethylenterephthalatfolie die Deckschicht des lichtempfindlichen Aufzeichnungselements.

Zur Herstellung einer Reliefdruckform wurde die Polyester-Deckfolie abgezogen, wobei die Polyamidschicht auf der photopolymerisierbaren Aufzeichnungsschicht verblieb. Dann wurde die Aufzeichnungsschicht 10 Minuten lang hierdurch mit Hilfe eines handelsüblichen Flachbelichters bildmäßig belichtet. Anschließend wurde das bildmäßig belichtete Aufzeichnungselement in einem Bürstenwascher mit einem Gemisch aus 3 Vol.-Teilen Tetrachlorethylen und einem 1 Vol.-Teil n-Butanol entwickelt, mit einer 0,4 %igen Bromlösung 3 Minuten lang nachbehandelt, getrocknet und anschließend 10 Minuten vollflächig nachbelichtet. Man erhielt eine Flexodruckform mit sauber ausgebildetem Relief, das scharfe Kanten und gute Zwischentiefen in den gerasteten Halbtonflächen zeigte. Beim Drucken auf einem Flexodruckwerk erhielt man ausgezeichnete Druckergebnisse. Die Druckform zeigte selbst nach mehrstündigem Druck keinerlei Abrieb, Risse oder Deformationen.

### Beispiel 6

Beispiel 5 wurde wiederholt, nur daß diesmal zur Herstellung der photopolymerisierbaren Aufzeichnungsschicht ein photopolymerisierbares Gemisch gemäß Beispiel 2 eingesetzt wurde. Mit der so hergestellten Flexodruckform konnten originalgetreue Drucke mit sehr hoher Auflage hergestellt werden.

### Beispiel 7

Zunächst wurde eine lichtempfindliche Aufzeichnungsschicht hergestellt, indem in einen Zweischneckenextruder 80 Teile des Blockcopolymerisats P-1 gemäß Tabelle 1 eingetragen und bei 140°C aufgeschmolzen wurden. In die Schmelze wurden anschließend 3 Teile 1,6-Hexandiol-diacrylat, 3 Teile 1,6-Hexandioldimethacrylat, 1 Teil Benzildimethylketal, 6 Teile Weißöl gemäß Beispiel 3, 6 Teile des p-Methylstyrol-α-Methylstyrol-Copolymerisats gemäß Beispiel 3, 1 Teil 2,6-Di-tert.-butyl-p-kresol und 0,005 Teile Sudantiefschwarz SSBB eingemischt. Nach dem Homogenisieren wurde das photopolymerisierbare Gemisch durch eine Breitschlitzdüse ausgetragen und mit Hilfe einer Kalanderwalze zu einer 3,0 mm dicken photopolymerisierbaren Aufzeichnungsschicht zwischen zwei jeweils 125 µm dicken Polyesterfolien geformt.

Wie im Beispiel der EP-A-231 902 beschrieben, wurde die lichtempfindliche Aufzeichnungsschicht exakt auf den Umfang eines dünnwandigen Druckzylinders mit Nickel-Oberfläche zugeschnitten und nach Abziehen der Polyester-Trägerfolie so auf den Druckzylinder aufgebracht, daß die Endkanten der Aufzeichnungsschicht bündig aneinander stießen. Vor dem Aufbringen auf den Druckzylinder war die photopolymerisierbare Aufzeichnungsschicht noch durch einen Rasterfilm mit einem Raster von 5 Linien/cm und einem 10 %igen Tonwert in einem Röhrenflachbelichter rückseitig vorbelichtet worden. Die aneinanderstoßenden Kanten der auf den Druckzylinder aufgebrachten photopolymerisierbaren Aufzeichnungsschicht wurden anschließend bei ca. 130°C unter auf die Oberfläche wirkenden Druck miteinander verschweißt. Nach dem Verschweißen der Rohschicht konnte diese mit einem Schleifstein glatt und maßgenau geschliffen werden. Aus der geschliffenen Rohschicht wurde durch bildmäßiges Belichten, Auswaschen, Trocknen und Nachbelichten eine endlose Druckform für den Flexodruck hergestellt. Die Druckschicht zeigte keine Anisotropie, d. h. das Rückstellverhalten längs und quer zur Extrusionsrichtung war gleich, woraus ein sehr gutes Druckverhalten resultierte. Die so erhaltenen Endlosdruckformen erlaubten einen einwandfreien Druck und zeichneten sich durch eine hohe Resistenz gegenüber Ozon aus. Die Eigenschaften der erhaltenen Endlosdruckform sind in Tabelle 2 zusammmengestellt.

### Beispiel 8

Es wurde wie in Beispiel 7 gearbeitet, nur daß anstelle des Blockcopolymerisats P-1 diesmal zur Herstellung der lichtempfindlichen Aufzeichnungsschicht das Blockcopolymerisat P-5 gemäß Tabelle 1 eingesetzt wurde. Die erhaltene Endlosdruckform zeichnete sich durch ähnlich gute Eigenschaften aus wie die gemäß Beispiel 7; ihre Eigenschaften sind ebenfalls in Tabelle 2 enthalten.

### Vergleichsversuch

Es wurde wie in Beispiel 7 gearbeitet, nur daß anstelle des Blockcopolymerisats P-1 diesmal zur Herstellung der lichtempfindlichen Aufzeichnungsschicht als Bindemittel ein elastomeres Polystyrol-Polybutadien-Polystyrol-3-Blockcopolymerisat gemäß Beispiel 1 der GB-A-1 366 769 eingesetzt wurde. Die so hergestellte lichtempfindliche Aufzeichnungsschicht konnte nach dem Aufbringen auf den Druckzylinder und Verschweißen der Endkanten nur mangelhaft geschliffen werden, obwohl ihre Rohschichthärte der der Aufzeichnungsschicht gemäß Beispiel 7 entsprach. Auch zeigte die nach dem Vergleichsbeispiel hergestellte Druckschicht eine deutlich höhere Anisotropie und eine wesentlich geringere Ozonresistenz als die Druckformen gemäß Beispielen 7 und 8. Die Ergebnisse sind ebenfalls in Tabelle 2 wiedergegeben.

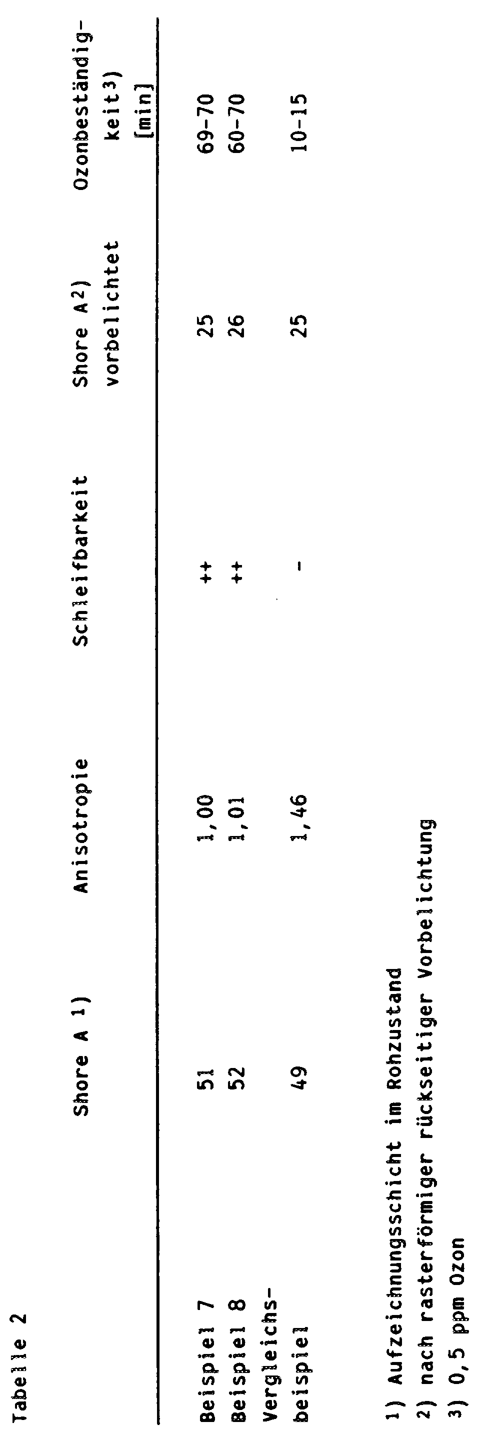

## Patentansprüche

1. Photopolymerisierbares Gemisch, enthaltend
(a) wenigstens 40 Gew.-%, bezogen auf das photopolymerisierbare Gemisch, mindestens eines elastomeren Blockcopolymerisats als polymeres Bindemittel,
(b) wenigstens 1 Gew.-%, bezogen auf das photopolymerisierbare Gemisch, mindestens einer mit dem polymeren Bindemittel (a) verträglichen, photopolymerisierbaren, ethylenisch ungesättigten niedermolekularen Verbindung,
(c) 0,01 bis 10 Gew.-%, bezogen auf das photopolymerisierbare Gemisch, mindestens eines Photopolymerisationsinitiators sowie
(d) 0 bis 40 Gew.-%, bezogen auf das photopolymerisierbare Gemisch, an weiteren Hilfs- und/oder Zusatzstoffen,
dadurch gekennzeichnet, daß als Bindemittel (a) elastomere Vinylaromat/Dien-Blockcopolymerisate mit mindestens einem thermoplastischen, nicht-elastomeren Polymerblock A und mindestens einem elastomeren Polymerblock B enthalten sind, welche Endgruppen der allgemeinen Formeln (I), (II) oder (III) 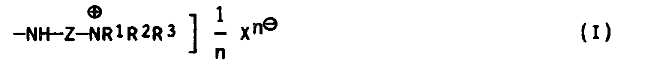 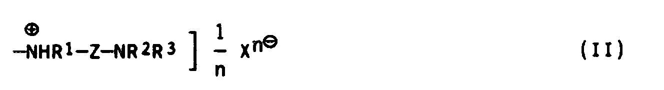 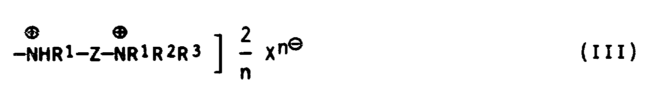 aufweisen, worin bedeuten
Z: einen zweibindigen, ggf. substituierten Kohlenwasserstoff-Rest oder eine direkte Einfachbindung,
R¹: H oder einen organischen Quaternisierungsrest, wie eine Alkylgruppe,
R, R³: gleich oder verschieden und unabhängig voneinander, ein Wasserstoffatom, einen aliphatischen, cycloaliphatischen oder aromatischen Rest, insbesondere mit 1 bis 12 C-Atomen, eine -CO-Y-COOH-Gruppe (worin Y steht für den Rest eines cyclischen Dicarbonsäureanhydrids) oder R und R³ zusammen eine Brücke mit 3 bis 12, ggf. durch aliphatische oder aromatische Reste substituierten, Kohlenstoffgliedern,
X: einen anorganischen oder organischen Säurerest sowie
n: eine ganze Zahl, die die negative Wertigkeit des Säurerests X angibt.

2. Photopolymerisierbares Gemisch gemäß Anspruch 1, dadurch gekennzeichnet, daß als Bindemittel (a) elastomere Vinylaromat/Dien-Blockcopolymerisate der allgemeinen Formel (IV)
(A-B)̵ₚE (IV)
enthalten sind, worin A für einen thermoplastischen, nicht-elastomeren Polyvinylaromat-Block, B für einen elastomeren Polydien-Block, p für eine ganze Zahl im Bereich von 1 bis 4, insbesondere für die Zahl 1, und E für eine Endgruppe der allgemeinen Formeln (I), (II) oder (III) stehen.

3. Photopolymerisierbares Gemisch nach Anspruch 1 oder 2, dadurch gekennzeichnet, daß A für einen Homopolystyrolblock oder für einen Styrol-Copolymerisatblock mit untergeordneten Mengen an einpolymerisiertem Butadien und/oder Isopren steht.

4. Photopolymerisierbares Gemisch nach einem der Ansprüche 1 bis 3, dadurch gekennzeichnet, daß B ein Homo- oder Copolymerisat-Block aus Butadien und/oder Isopren oder ein Copolymerisatblock aus Butadien und/oder Isopren mit untergeordneten Mengen an einpolymerisiertem Styrol bedeutet.

5. Photopolymerisierbares Gemisch nach einem der Ansprüche 1 bis 4, dadurch gekennzeichnet, daß die als Bindemittel (a) enthaltenen elastomeren Vinylaromat/Dien-Blockcopolymerisate mindestens eine der folgenden Endgruppen aufweisen 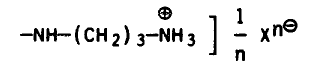 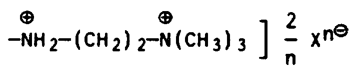 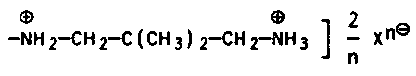 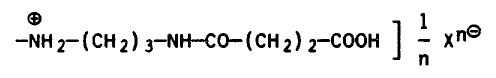 worin X für den Rest einer anorganischen oder organischen Säure und n für die negative Wertigkeit dieser Säure stehen.

6. Photopolymerisierbares Gemisch nach einem der Ansprüche 1 bis 5, dadurch gekennzeichnet, daß X den Oxalsäure- oder Phosphorsäure-Rest darstellt.

7. Photopolymerisierbares Gemisch nach einem der Ansprüche 1 bis 6, dadurch gekennzeichnet, daß die als Bindemittel (a) enthaltenen elastomeren Vinylaromat/Dien-Blockcopolymerisate mit den kationischen Endgruppen der allgemeinen Formel (I), (II) oder (III) einen bis zu 5-molaren überschuß an der Säure HₙX über den Äquivalenzpunkt hinaus je Mol der kationischen Kettenenden der Blockcopolymerisate enthalten.

8. Lichtempfindliches Aufzeichnungselement, insbesondere zur Herstellung von Druckplatten für den Flexodruck, mit einer auf einem dimensionsstabilen Träger haftfest aufgebrachten photopolymerisierbaren Aufzeichnungsschicht, dadurch gekennzeichnet, daß die photopolymerisierbare Aufzeichnungsschicht aus einem photopolymerisierbaren Gemisch nach einem der Ansprüche 1 bis 7 gebildet ist.

## Claims

1. A photopolymerizable mixture comprising
(a) at least 40% by weight, based on the photopolymerizable mixture, of at least one elastomeric block copolymer as polymeric binder,
(b) at least 1% by weight, based on the photopolymerizable mixture, of at least one photopolymerizable, ethylenically unsaturated low molecular weight compound that is compatible with the polymeric binder (a),
(c) from 0.01 to 10% by weight, based on the photopolymerizable mixture, of at least one photopolymerization initiator, and also
(d) from 0 to 40% by weight, based on the photopolymerizable mixture, of further auxiliary and/or additive substances,
characterized in that binder (a) comprises elastomeric aromatic vinyl/diene block copolymers having at least one thermoplastic, nonelastomeric polymer block A and at least one elastomeric polymer block B, which have end groups of the general formulae (I), (II) or (III) 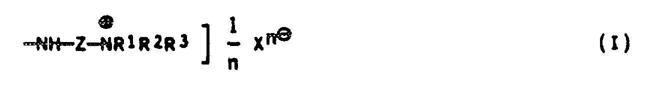 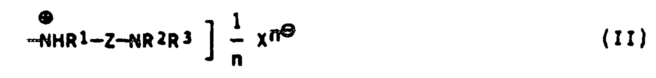 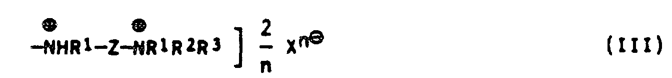 where
Z is a bivalent, substituted or unsubstituted hydrocarbon radical or a single bond,
R¹ is H or an organic quaternization radical, such as an alkyl group,
R and R³ are each identical or different and independently of each other a hydrogen atom, an aliphatic, cycloaliphatic or aromatic radical, in particular having from 1 to 12 carbon atoms, a -CO-Y-COOH- group (where Y is the radical of a cyclic dicarboxylic anhydride), or R and R³ together are a bridge having from 3 to 12 carbon members optionally substituted by aliphatic or aromatic radicals,
X is an inorganic or organic acid radical, and also
n is an integer which indicates the negative valency of the acid radical X.

2. A photopolymerizable mixture as claimed in claim 1, characterized in that binder (a) comprises elastomeric aromatic vinyl/diene block copolymers of the general formula (IV)
(A-B)̵ₚE (IV)
where A is a thermoplastic, nonelastomeric poly(aromatic vinyl) block, B is an elastomeric polydiene block, p is an integer from 1 to 4, in particular 1, and E is an end group of the general formulae (I), (II) or (III).

3. A photopolymerizable mixture as claimed in claim 1 or 2, characterized in that A is a homopolystyrene block or a styrene copolymer block with minor amounts of copolymerized butadiene and/or isoprene.

4. A photopolymerizable mixture as claimed in any of claims 1 to 3, characterized in that B is a homo- or copolymer block of butadiene and/or isoprene or a copolymer block of butadiene and/or isoprene with minor amounts of copolymerized styrene.

5. A photopolymerizable mixture as claimed in any of claims 1 to 4, characterized in that the elastomeric aromatic vinyl/diene block copolymers present as binder (a) have at least one of the following end groups: 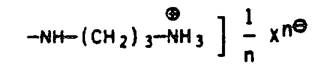 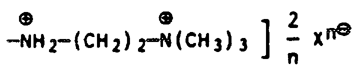 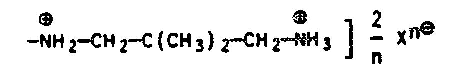 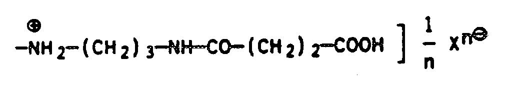 where X is the radical of an inorganic or organic acid and n is the negative valency of this acid.

6. A photopolymerizable mixture as claimed in any of claims 1 to 5, characterized in that X is the oxalic acid or phosphoric acid radical.

7. A photopolymerizable mixture as claimed in any of claims 1 to 6, characterized in that the binder (a) elastomeric aromatic vinyl/diene block copolymers with the cationic end groups of the general formula (I), (II) or (III) contain an excess of the acid HₙX beyond the equivalence point of up to 5 mol per mole of the cationic chain ends of the block copolymers.

8. A light-sensitive recording element, in particular for producing printing plates for flexographic printing, comprising a photopolymerizable recording layer firmly adherent on a dimensionally stable support, characterized in that the photopolymerizable recording layer is formed by a photopolymerizable mixture as claimed in any of claims 1 to 7.

## Revendications

1. Mélange photo-polymérisable contenant :
(a) au moins 40 % en poids, par rapport au mélange photo-polymérisable, d'au moins un copolymérisat à bloc élastomère servant de liant polymère,
(b) au moins 1 % en poids, par rapport au mélange photo-polymérisable, d'au moins un composé à faible poids moléculaire non saturé éthyléniquement photo-polymérisable compatible avec le liant polymère (a),
(c) de 0,01 à 10 % en poids, par rapport au mélange photo-polymérisable, d'au moins un photo-initiateur de polymérisation ainsi que
(d) de O à 40 % en poids, par rapport au mélange photo-polymérisable, d'autres substances auxiliaires et/ou additives,
caractérisé en ce que sont contenus comme liants (a) des copolymérisats à bloc vinyl-aromates/diène ayant au moins un bloc polymère A thermoplastique non élastomère et au moins un bloc polymère B élastomère, présentant des groupes finaux de formules générales (I), (II) ou (III) 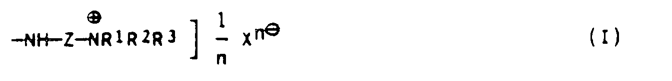 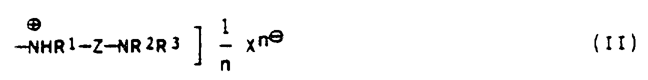 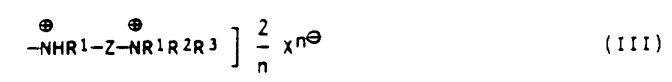 dans lesquels
Z: est un résidu d'hydrocarbure à deux liaisons le cas échéant substituées ou une liaison simple directe,
R¹ : H ou un résidu de quaternisation organique tel qu'un groupe alkyle
R, R³ : identiques ou différents et indépendants l'un de l'autre, un atome d'hydrogène, un résidu aliphatique, cycloaliphatique ou aromatique, en particulier comprenant de 1 à 12 atomes de C, un groupe -CO-Y-COOH (dans lequel Y est le résidu d'un anhydride d'acide bicarbonique cyclique) ou R et R³ forment conjointement un pont avec 3 à 12 liaisons carbone le cas échéant substitué par des résidus aliphatiques ou aromatiques,
X : est un résidu acide minéral ou organique ainsi que
n : un nombre entier indiquant la valence négative du résidu acide X.

2. Mélange photo-polymérisable selon la revendication 1, caractérisé en ce que sont contenus comme liants (a) des copolymérisats à bloc élastomères vinyl-aromates/diène de formules générales (IV),
(A-B)̵ₚE (IV)
A étant un bloc de polyvinyle aromate thermoplastique non élastomère, B un bloc de polydiène élastomère, p un nombre entier situé dans la plage allant de 1 à 4, en particulier le nombre 1, et E un groupe final des formules générales (I), (II), (III).

3. Mélange photo-polymérisable selon la revendication 1 ou 2, caractérisé en ce que A est un bloc de homopolystyrène ou un bloc de copolymérisat de styrène avec des quantités secondaires de butadiène polymérisée et/ou d'isoprène.

4. Mélange photo-polymérisable selon l'une des revendications 1 à 3, caractérisé en ce que B est un bloc homo ou copolymérisat de butadiène et/ou d'isoprène et un bloc copolymérisat de butadiène et/ou d'isoprène avec des quantités secondaires de styrène polymérisé.

5. Mélange photo-polymérisable selon l'une des revendications 1 à 4, caractérisé en ce que les blocs polymérisats vinyl-aromate/diène élastomère contenus comme liants (a) présentent au moins l'un des groupes finaux suivants : 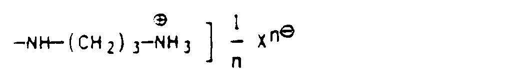 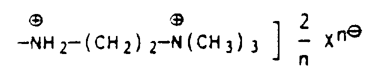 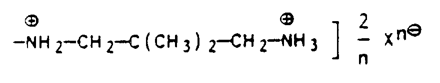 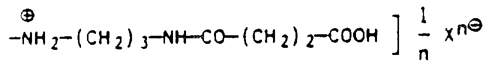 où X est le résidu d'un acide minéral ou organique et n est la valence négative de cet acide.

6. Mélange photo-polymérisable selon l'une des revendications 1 à 5, caractérisé en ce que X représente le résidu d'acide oxalique ou d'acide phosphorique.

7. Mélange photo-polymérisable selon l'une des revendications 1 à 6, caractérisé en ce que les copolymérisats à bloc vinyl-aromate/diène élastomère contenus comme liants (a) avec les groupes finaux cationiques de formule générale (I), (II) ou (III) contiennent un excès allant jusqu'à un rapport molaire de 5 en acide HₙX par rapport au point d'équivalence pour chaque mole des extrémités de chaînes cationiques du copolymérisat à bloc.

8. Elément d'affichage sensible à la lumière en particulier pour fabriquer des clichés pour l'impression flexographique, avec une couche d'enregistrement photo-polymérisable appliquée d'une façon résistante à l'adhésion ou sur un support de dimension stable, caractérisé en ce que la couche d'enregistrement photo-polymérisable est constituée d'un mélange photo-polymérisable selon l'une des revendications 1 à 7.
